# EUROPEAN PATENT APPLICATION

(11) **EP 2 620 757 A1**
(43) Date of publication of application: **31.07.2013**
(21) Application number: 13152494.4
(22) Date of filing: 24.01.2013
(51) Int. Cl.: G01L 19/14

(54) **Small form factor microfused silicon strain gage (MSG) pressure sensor packaging**

(30) Priority: 27.01.2012 US 201261591466 P
(71) Applicant: Sensata Technologies Massachusetts, Inc., Attleboro MA 02703 (US)
(72) Inventor: Petrarca, Neil S., Warwick, RI Rhode Island 02886 (US)
(74) Representative: Legg, Cyrus James Grahame

(57) **Abstract**

A pressure sensor assembly (10) includes a base including a radially offset pressure port. An electronics package (24) may be included within a housing generally alongside the offset pressure port. Accordingly, the pressure sensor assembly exhibits a substantially smaller diameter than previously achieved. Methods of fabrication are provided.

## Description

### BACKGROUND OF THE INVENTION

### 1. Field of the Invention

This disclosure relates generally to pressure transducers and more particularly to such transducers using strain gauge technology for sensing pressure change to produce an electrical signal.

### 2. Description of the Related Art

Pressure sensors that use Microfused Silicon Strain Gage (MSG) technology have become popular for a variety of applications. These pressure sensors are generally small in form. However, pressure sensors that use MSG technology generally exhibit and overall sensor diameter that is about 12 mm or higher. Accordingly, this technology has not yet realized its potential.

One reason MSG pressure sensors exhibit size limitations is that packaging design has evolved into using a single, circular printed circuit board for population of the electronics and electrical interconnection to a customer's system.

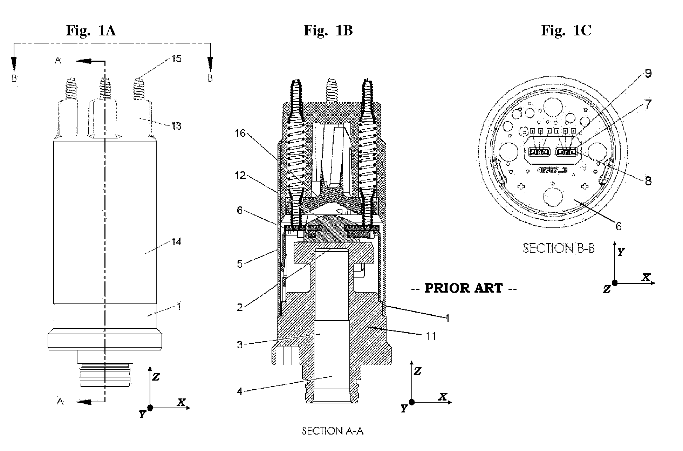

As new applications call for the sensing of pressure at a multiple locations, the provision of discrete pressure sensors with full conditioning electronics results in a relatively high total pressure sensor cost as well as a significant total spatial requirement. Various designs for electro-hydraulic brake systems, for example in a vehicular environment, often call for sensing of fluid pressure in multiple locations. The large form factor of present day MSG pressure sensors presents designers with real limitations when designing such systems. In order to provide some context, a prior art pressure sensor is introduced in FIG. 1.

Referring to FIG. 1, there is shown a prior art pressure sensor 1. FIG. 1A provides a side view of a prior art pressure sensor 1. Generally, the prior art pressure sensor 1 is contained within a housing 14. The housing 14 includes a spring guide 13, which may include a plurality of springs 15. The plurality of springs 15 may protrude from the top of the spring guide 13. FIG. 1B is a cutaway view of the prior art pressure sensor 1 depicted in FIG. 1A, wherein the cutaway view is along Axis A.

In FIG. 1B, the prior art pressure sensor 1 is shown disposed about a longitudinal axis 4. A sensing element diaphragm 2 is exposed to an external environment (i.e., a pressurized environment) through an inner borehole 3 that is open to the environment. The inner borehole 3 is centrally disposed about Axis A and provided within a pressure port 11. Mounted onto the pressure port 11, and generally perpendicular to the longitudinal axis 4, is a printed circuit board (PCB) 6 (which is disposed along Axis B as shown in FIG. 1A). Generally, the PCB 6 is disposed onto the pressure port 11 with a suitable gel 12 therebetween. A support ring 5 is circumferentially disposed about the PCB 6 and serves to maintain centering of the PCB 6, while the springs 15 cooperate with spring retainer 16.

Referring to FIG. 1C, the PCB 6 is host to a glass substrate 8 onto which at least one strain gauge 7 is mounted. Each strain gauge 7 is electrically coupled to the PCB 6 by a plurality of bonded wires 9. Unfortunately, in the prior art pressure sensor 1, the electronics that are required to provide usable signals from the strain gauges 7 result in a PCB 6 of a diameter that is greater than desired.

What are needed are pressure sensors of a smaller form that are presently available.

### SUMMARY OF THE INVENTION

In one embodiment, a pressure sensor assembly is disclosed. The pressure sensor assembly includes a sense element configured to be exposed to a pressure environment. The sense element is generally offset from a central axis of the assembly. An electronics package is disposed generally alongside of the pressure environment and electrically coupled to the sense element. A housing is disposed about the sense element and electronics package with a connector that is joined to the housing and electrically connected to the electronics package, the connector including an external interface.

In the assembly, the connector may comprise an external interface adapted for external communication.

In another embodiment, a method for fabricating a pressure sensor is provided. The method includes selecting a pressure port including a base and a neck, the neck radially offset from a central axis of the base; disposing an electronics package alongside the neck of the pressure port, the electronics package configured for sensing pressure in the pressure port; and disposing a housing over the base, the pressure port and the electronics package.

In the method, disposing the housing may comprise joining the housing to the base. Joining the housing to the base may comprise welding.

In yet another embodiment, a pressure sensor assembly is provided. The assembly includes a pressure port that is radially offset from a central axis of the sensor assembly; an electronics package disposed on a lead frame installed onto a carrier, the electronics package disposed alongside the pressure port and coupled to at least one pressure sensor of a sense element of the pressure port by at least one bonding wire that is bonded to the at least one pressure sensor; a housing disposed over the electronics package and pressure port and secured to a base of the pressure port; and a connector joined to the housing at an end of the housing that is opposite to the base of the pressure port, the connector electrically coupled to the electronics package in providing an external interface to the pressure sensor assembly.

The pressure sensor may comprise at least one strain gauge. The housing may exhibit a diameter less than about 8 millimeters.

### BRIEF DESCRIPTION OF THE DRAWINGS

The features and advantages of the invention are apparent from the following description taken in conjunction with the accompanying drawings in which:

FIG. 1A through FIG. 1C, collectively referred to herein as FIG. 1, illustrate a prior art pressure sensor that makes use of Microfused Silicon Strain Gage (MSG) technology;

FIG. 2A through FIG. 2C, collectively referred to herein as FIG. 2, illustrate aspects of a compact pressure sensor;

FIG. 3A through FIG. 3D, collectively referred to herein as FIG. 3, illustrate aspects of a sense element assembly for use in the compact pressure sensor of FIG. 2;

FIG. 4A through FIG. 4B, collectively referred to herein as FIG. 4, illustrate aspects of a carrier for mounting on the sense element assembly of FIG. 3;

FIG. 5A through FIG. 5D, collectively referred to herein as FIG. 5, illustrate the sense element assembly of FIG. 3 with the carrier of FIG. 4 mounted thereon;

FIG. 6A through FIG. 6D, collectively referred to herein as FIG. 6, illustrate the assembly of FIG. 5 with a housing disposed thereon; and,

FIG. 7A through FIG. 7B, collectively referred to herein as FIG. 7, illustrate a connector for providing an external interface with the assembly of FIG 6.

### DETAILED DESCRIPTION OF THE INVENTION

Disclosed herein is a compact pressure sensor assembly. The pressure sensor assembly exhibits a narrow body. The narrow body results from, among other things, electronics configurations as disclosed herein.

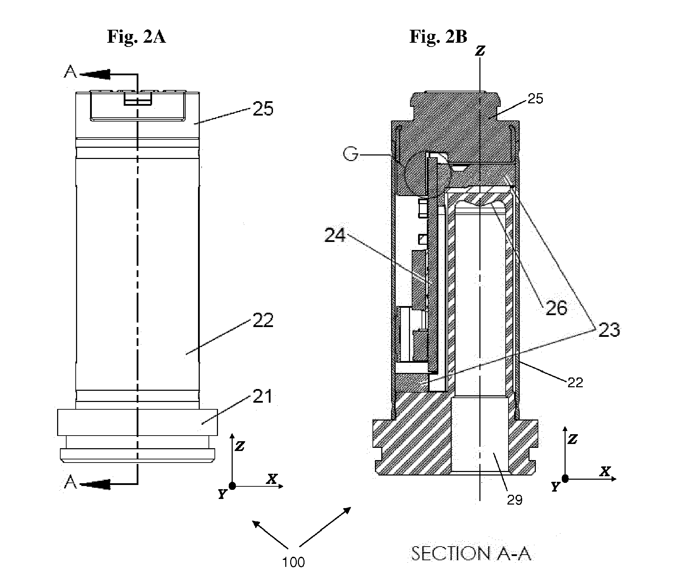

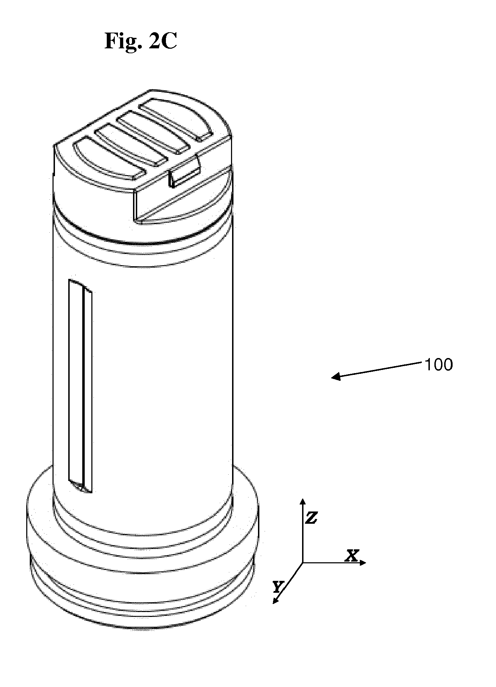

Referring now to FIG. 2, an assembled compact pressure sensor 100 is shown. FIG. 2A provides a side view of the compact pressure sensor 100. Generally, the compact pressure sensor 100 includes a port 21, a housing 22, and a connector 25.

FIG. 2B provides a cutaway view of the compact pressure sensor 100. As shown in this diagram, the compact pressure sensor 100 includes the port 21, the housing 22, and the connector 25. Disposed over the port 21 and within the housing 22, is a carrier 23. The carrier 23 carries a vertically disposed printed circuit board (PCB) 24. At a top of the port 21 is a sense element diaphragm 26. As will be shown further herein, at least one strain gauge 7 may be disposed on the sense element diaphragm 26. Through use of a lead frame (shown further herein), the at least one strain gauge 7 is further coupled to the vertically disposed printed circuit board (PCB) 24. The sensing element diaphragm 26 is disposed at a top of an inner borehole 29. The port 21 is generally open at the base, such that the inner borehole 29 is exposed to the pressure environment. In this embodiment, the inner borehole 29 extends along a longitudinal axis, Z. FIG. 2C depicts an embodiment of an assembled compact pressure sensor 100.

Note that the term "pressure environment," "pressurized environment" and other similar terms are not meant to imply a high pressure environment or a low-pressure environment and our without regard a degree of pressure. Simply put, such environments are merely an environment for the sense element to sense pressure over its operational range.

Note that terminology such as "top," "bottom," and other such orientation all terms are provided herein to aid in description of the compact pressure sensor 100, and are not meant to describe a position of the compact pressure sensor 100. Generally, such relative terminology is provided with regard to the illustrations provided, and is not limiting of the teachings herein. Other terminology may be used. For example, and as a matter of convention, the base of the port 21 may be referred to as a "proximal end," while the portion of the compact pressure sensor that includes the connector 25 may be referred to as a "distal end." However, and again merely for purposes of explaining the teachings herein, such terminology is illustrative and is not limiting of the teachings herein.

It should be noted that the drawings included herein generally includes coordinates systems. The coordinate systems are provided to relate the various views to one another. As with the case of various arbitrary terminology such as "top," and "bottom," the coordinate systems are provided for convenience and ease of referencing. These are not meant to be limiting of the invention. That is the coordinate systems do not describe an orientation for the compact pressure sensor 100. Generally, the compact pressure sensor 100 may be used in any orientation that is deemed appropriate by a manufacturer, designer, user or other similarly interested party.

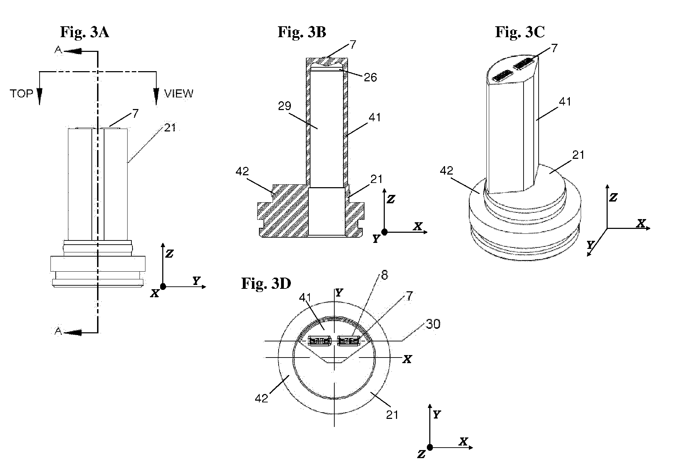

Turning to FIG. 3, the port 21 is shown in greater detail. In FIG. 3A, a side view of the port 21 is shown. In this embodiment, the port 21 includes a base 42 (referred to herein as "port base" and by other similar terms), and a neck 41 (referred to herein as "port neck" and by other similar terms). As shown in FIG. 3B, the port 21 includes an inner borehole 29 and a sensing element diaphragm 26. Generally, the port 21 is open to a pressure environment at a bottom thereof. Accordingly, the pressure environment extends through the inner borehole 29 to the sensing element diaphragm 26 where pressure sensing occurs during operation. FIG. 3C provides an isometric view of the port 21. As can be better appreciated in this view, the port base 42 may include features for mounting of the compact pressure sensor 100 as well as features for retention of the housing 22. Disposed on a top of the sensing element diaphragm 26 are the at least one strain gauges 7. FIG. 3D shows a downward looking view. In the downward looking view (top view), it may be seen that the at least one strain gauge 7, the neck 41 (and therefore the inner borehole 29) are offset 30 from an imaginary center axis, *X,* which bisects the compact pressure sensor 100. That is, the neck 41 is radially offset from the center axis, *X*, of the base 42. The offset 30 is generally an appreciable offset that may be described as distance, D.

By providing the offset 30 additional usable room inside the housing 22 is made available. That is, by incorporating the offset 30, it becomes possible to re-orient components such as the PCB 24.

As a matter of convenience, a combination of the at least one strain gauge 7 and the sensing element diaphragm 26 may be referred to as a "sense element." It should be noted that other embodiments of the sense element may be realized. For example, the sense element may include other types of sensing electronics other than the at least one strain gauge 7. Various designs of sensing element diaphragm's 26 may be used.

Generally, the port 21 is fabricated from a suitable material such as a metal, metal alloy, or metallic material. The port 21 may actually be assembled from subcomponents and therefore include a diversity of materials. For example, the port 21 may also include high temperature, high strength polymer material. An exemplary polymer includes acrylonitrile butadiene styrene (ABS) plastic.

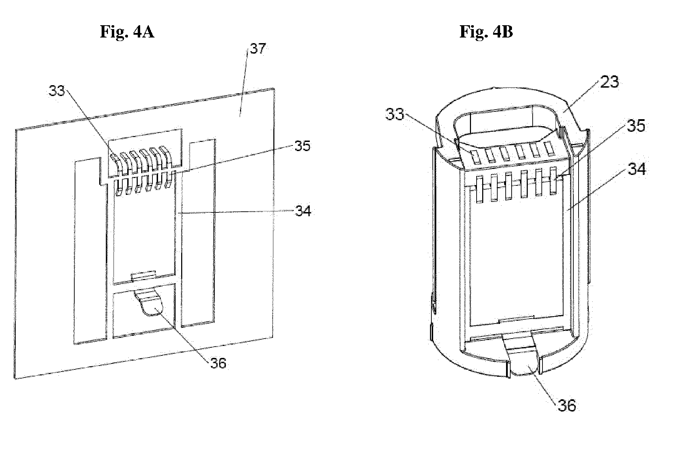

Referring now to FIG. 4, aspects of the carrier 23 are shown. In FIG. 4A, a lead frame template 37 is shown. The lead frame template 37 may be stamped of a conductive metal such as stainless steel, and may be plated stainless steel. The lead frame template 37 provides the lead frame 34. The lead frame 34 includes a ground tab 36. The ground tab 36 is suitable for grounding of the PCB 24 when installed. Among other things, the lead frame 34 is configured to provide for structural integrity and fitment with the carrier 23. A plurality of wirebond pads 33 are complemented with a plurality of connecting pads 35. The wirebond pads 33 and the connecting pads 35 may be plated with plating material. The plating material may include at least one of silver and gold and another material that provides for increased electrical conductivity.

The lead frame template 37 is designed for conformity with the carrier 23. As shown in FIG. 4B, when installed in the carrier 23, the lead frame 34 provides for electrical communication from the at least one strain gauge 7 to the PCB 24. That is, when the compact pressure sensor 100 is assembled, the plurality of wirebond pads 33 of the lead frame 34 are electrically coupled to the at least one strain gauge 7. In turn the plurality of connecting pads 35 are electrically coupled to the PCB 24. Accordingly, the PCB 24 may be disposed in a vertical position in the lead frame 34.

In general, it may be considered that the lead frame 34 serves as a host to the PCB 24 and provides for orientation of the PCB 24 in an angular relationship to the sense element. That is, when the PCB 24 is mounted in the lead frame 34, it is not necessary that the PCB 24 be disposed in a plane that is perpendicular to a longitudinal axis (axis Z) of the pressure assembly (i.e., an angular relationship of zero degrees, or generally alongside or parallel to the longitudinal axis). As shown herein, the PCB 24 is disposed vertically, and generally alongside of the borehole 29. However, the lead frame 34 provides a great deal of flexibility in design, and therefore this is not a requirement.

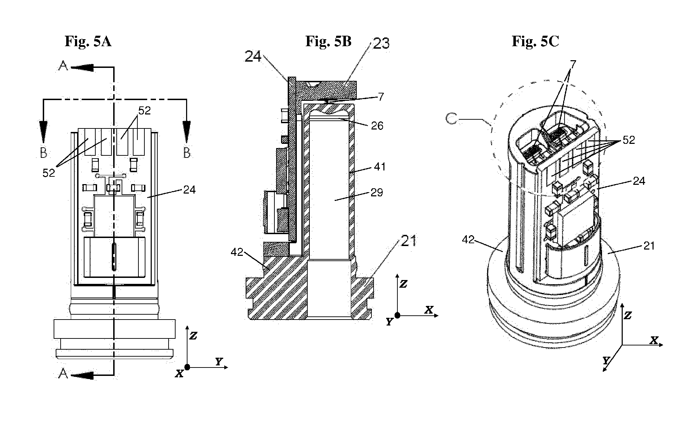

Referring now to FIG. 5A, a side view of the pressure port 21 with the PCB 24 mounted thereon is provided. Visible in this illustration is a plurality of external contacts 52 which are provided at the top of the PCB 24. As shown in this illustration, the PCB 24 is vertically mounted. That is, and as shown in FIG. 5B, the PCB 24 is disposed in a geometry that is generally parallel to the inner borehole 29 and the longitudinal axis, *Z*, (shown in FIG. 2B). It is not required that the PCB 20 be precisely parallel to the longitudinal axis, *Z*. In this orientation, the PCB 24 no longer resides above the pressure sensor diaphragm 26. Thus, the greater diameter required for the pressure port 21 as a result of the placement of the prior art PCB 6 is avoided. This is further shown in FIG. 5C.

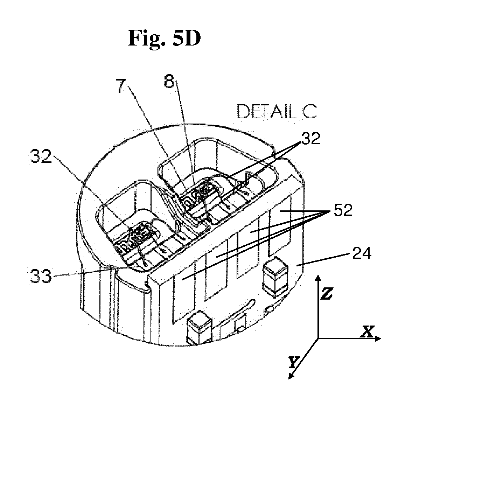

In FIG. 5C, the pressure port 21 has the carrier 23 mounted thereon. The PCB 24 is mounted onto the carrier 23. The PCB 24 is electrically connected to the at least one strain gauge 7 (in this case, there are 2 strain gauges 7). This is better shown in the blowup section, C, which is depicted in FIG. 5D.

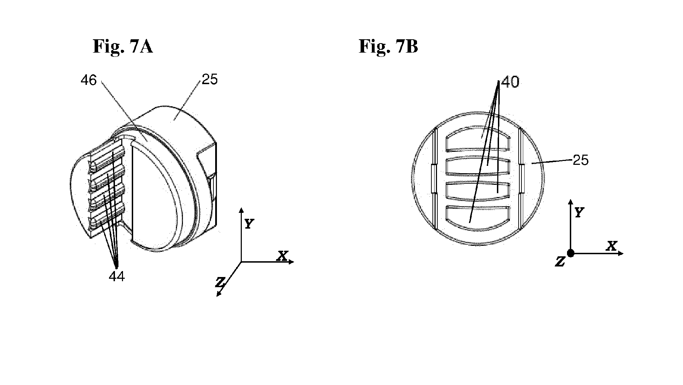

Referring to FIG. 5D, a close-up of electrical connections is shown. In this example, a plurality of bonded wires 32 are bonded to appropriate points of the strain gauges 7 in the wirebond pads 33 of the lead frame assembly. Note that electrical connections between the PCB 24 and the plurality of connecting pads 35 are not visible in this diagram. However, a plurality of external contacts 52 are shown. The external contacts 52 provide for electrical communication between the connector 25 (see FIG. 1, 7) and the PCB 24.

Note that, as discussed herein, the PCB 24 may be referred to as "an electronics package" and by other similar terms. Generally, the PCB 24 includes electronics components as appropriate for powering the sense element, obtaining data from the sense element, and communicating the data. Although the electronics package is presented as the PCB 24, it is not necessary that the electronics package be maintained entirely on a single PCB 24. Other configurations of electronics packages may be had, and are generally to be selected by a designer, manufacturer, user or other similarly interested party.

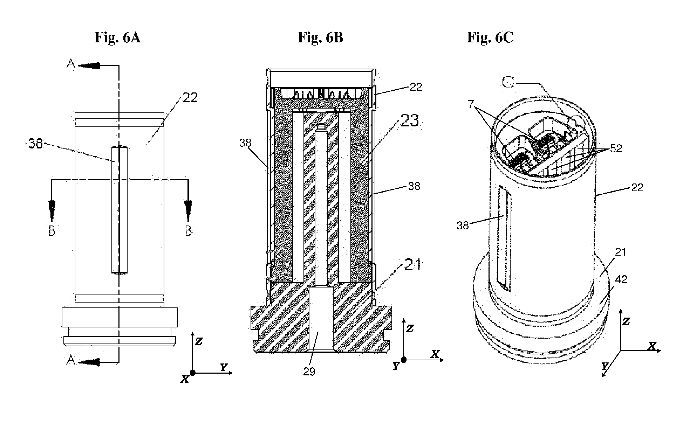

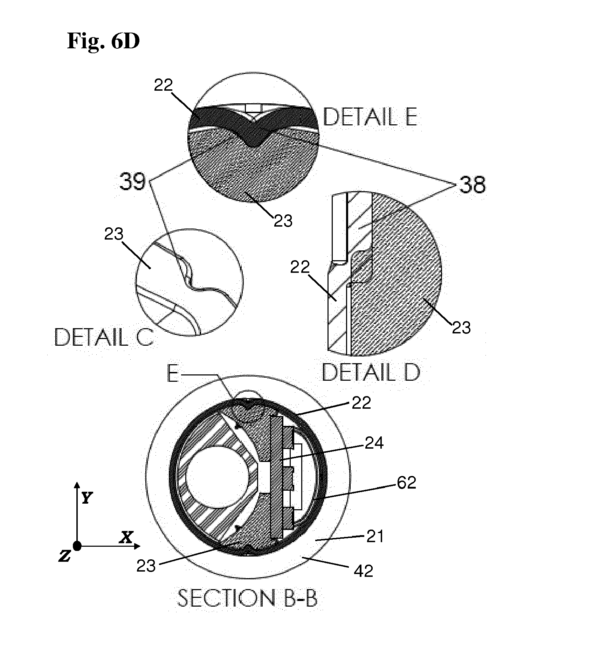

Refer now to FIG. 6 where aspects of installation of the housing 22 are shown and described. Generally, the housing 22 is fabricated from a suitable material such as a metal, metal alloy, or metallic material. The housing 22 may actually be assembled from subcomponents and therefore include a diversity of materials. For example, the housing 22 may also include high temperature, high strength polymer material. An exemplary polymer includes acrylonitrile butadiene styrene (ABS) plastic.

In FIG. 6A, a side view of the housing 22 disposed over the port is shown. The housing 22 is mated to the port base 42 at a joining section 61. In this example, the housing 22 is mated to the port base 42 by use of a weld. In one embodiment, the weld is a laser weld. Additionally, a side of the housing 22 includes at least one pinch rib 38. During assembly, the pinch rib 38 may be compressed to frictionally engage the carrier 23. Accordingly, the housing 22 is securely joined with the carrier 23 and the port 21.

In FIG. 6B, a cutaway of the assembly shown in FIG. 6A is shown. In this illustration, it may be seen that a plurality of pinch ribs 38 are employed. Specifically, in this example, it may be seen that there is a pinch rib 38 on the left side and an opposing pinch rib 38 on the right side. Referring now also to FIG. 6C, a top down view shows an indentation in an interior side of the housing 22. Close up detail of the pinch rib 38 is shown in FIG. 6D.

In FIG. 6D, Detail C and Detail E show a groove 39 in the carrier 23. As shown in Detail E, the housing 22 may be compressed to engage the groove 39. As shown in Detail D, compression of the pinch rib 38 results in a deformed region of the housing 22. Also shown in FIG. 6D, is a spacer element 62. In this embodiment, the spacer element 62 is mounted onto the PCB 24. The spacer element 62 generally provides for secure positioning of the PCB 24 in relation to the housing 22. That is, in this example, the spacer element 62 frictionally engages an interior wall of the housing 22. The frictional engagement of the housing 22 provides for from retention of the PCB 24 and the lead frame 34 and the carrier 23. Accordingly, vibrational influence and degradation of electrical connections between the PCB 24, the bonded wires 32, the wirebond pads 33, and the connecting pads 35 is minimized.

Turning to FIG. 7, an embodiment of the connector 25 is shown. In FIG. 7A, a plurality of internal contacts 44 are shown. The plurality of internal contacts 44 make electrical contact with the plurality of external contacts 52 when the connector 25 is secured in place. Generally, the connector 25 includes at least one feature that cooperates with the housing 22 to ensure secure mounting of the connector 25. In this example, the connector 25 includes a mounting surface 46. The mounting surface 46, in this embodiment, is a generally recessed circumference about a base of the connector 25. Accordingly, the base of the connector 25 may be inserted into a top of the housing 22. Another joining procedure may be performed to join the connector 25 to the housing 22. For example, the connector 25 may be welded to the housing 22. In one example, the connector 25 is laser welded to the housing 22.

In FIG. 7B, a top surface of the connector 25 is shown. In this example, the connector 25 includes a plurality of electrical contacts 44 that provide an interface 40. The interface 40 provides for electrical communication with external equipment as would be conventionally used with a pressure sensor, such as the prior art pressure sensor 1.

Having thus described embodiments of the compact pressure sensor 100, further aspects are introduced.

First, it should be noted that the design enhancements disclosed herein provide for a substantially smaller form factor for a pressure sensor. For example, the prior art pressure sensor 1 may have a diameter of about 12 mm. The compact pressure sensor 100 disclosed herein may have an equivalent diameter (i.e., a diameter taken a line may seem portion of the pressure sensor) that is about 8 mm. This is a fifty percent reduction in the diameter of the pressure sensor. Such a substantial reduction results in much greater opportunity for use of the pressure sensor.

The small sensor package solution also provides environmental protection for the pressure transducer. Techniques disclosed herein are also particularly conducive to ease of assembly with minimal chance of misalignment of components during assembly, which could cause damage to sensitive components within the transducer.

One feature of the pressure sensor assembly is an offset pressure port. A pressure sensing pedestal and diaphragm are oriented off center relative to a central axis or radial axis. Such placement provides additional space adjacent to the pressure port for packaging and situating electronics.

Another feature is vertical axial mounting of the printed circuit board. By mounting the printed circuit board along the longitudinal axis of the sensor, the printed circuit board population area is not limited primarily by a diameter of the sensor, but instead by a length of the sensor as well as the diameter. Since overall height is less of a constraint in typical automotive applications, there is more space for the printed circuit board to expand in the longitudinal axis of the sensor.

Another feature includes a printed circuit board carrier with an integrated lead frame. A plastic carrier with insert molded-leadframe provides a carrier to orient a PCB within the package. The insert molded leadframe provides an electrical connection method from the PCB to the sense element, via wire bonds. The leadframe provides a solution to transition from a vertical orientation of the PCB to a horizontal orientation that is needed for the wirebond pad surface to make wirebonds to the sense element. This component can also include features that contain a gel encapsulant used to cover gages.

Another feature is a modular connector configuration. Such a modular configuration accommodates multiple electrical connection systems between the sensor and customer system. This is achieved by an electrical connection between the sensor through PCB edge contacts and a connector with leaf spring contacts or other similar mechanism, which can then contact multiple different configurations of sensor connector styles.

It should be recognized that the teachings herein are merely illustrative and are not limiting of the invention. Further, one skilled in the art will recognize that additional components, configurations, arrangements and the like may be realized while remaining within the scope of this invention. For example, configurations of printed circuit boards, lead frame assemblies, pressure ports, strain gauges, pressure sensed diaphragms, housings, external connectors and the like may be varied from embodiments disclosed herein. Generally, design and/or application of components of the ultracapacitor and ultracapacitors making use of the electrodes are limited only by the needs of a system designer, manufacturer, operator and/or user and demands presented in any particular situation.

Further, various other components may be included and called upon for providing for aspects of the teachings herein. For example, additional materials, combinations of materials and/or omission of materials may be used to provide for added embodiments that are within the scope of the teachings herein. As discussed herein, terms such as "adapting," "configuring," "constructing" and the like may be considered to involve application of any of the techniques disclosed herein, as well as other analogous techniques (as may be presently known or later devised) to provide an intended result.

When introducing elements of the present invention or the embodiment(s) thereof, the articles "a," "an," and "the" are intended to mean that there are one or more of the elements. Similarly, the adjective "another," when used to introduce an element, is intended to mean one or more elements. The terms "including," "has" and "having" are intended to be inclusive such that there may be additional elements other than the listed elements.

It will be recognized that the various components or technologies may provide certain necessary or beneficial functionality or features. Accordingly, these functions and features as may be needed in support of the appended claims and variations thereof, are recognized as being inherently included as a part of the teachings herein and a part of the invention disclosed.

While the invention has been described with reference to exemplary embodiments, it will be understood that various changes may be made and equivalents may be substituted for elements thereof without departing from the scope of the invention. In addition, many modifications will be appreciated to adapt a particular instrument, situation or material to the teachings of the invention without departing from the essential scope thereof. Therefore, it is intended that the invention not be limited to the particular embodiment disclosed as the best mode contemplated for carrying out this invention but to be construed by the claims appended herein.

## Claims

1. A pressure sensor assembly (10) comprising:
a sense element (7) configured to be exposed to a pressure environment, the sense element (7) generally offset from a central axis (Z) of the assembly (10);
an electronics package (24) disposed generally alongside of the pressure environment and electrically coupled to the sense element (7);
a housing (22) disposed about the sense element (7) and electronics package (24); and
a connector (25) joined to the housing (22) and electrically connected to the electronics package (24), the connector (25) comprising an external interface (40).

2. The assembly (10) of claim 1, wherein the sense element (7) comprises at least one strain gauge.

3. The assembly (10) of claim 1, where in the electronics package (24) is disposed on a carrier (23).

4. The assembly (10) of claim 3, wherein the carrier (23) is disposed on a port (21) that comprises the sense element (7).

5. The assembly (10) of claim 3, further comprising a lead frame (34) adapted for hosting the electronics package (24) in an angular relationship to the sense element (7).

6. The assembly (10) of claim 3, where in the carrier (23) comprises a molded body.

7. The assembly (10) of claim 1, wherein the connector (40) comprises a plurality of contacts (44) adapted for making electrical contact with the electronics package (24).

8. A method for fabricating a pressure sensor assembly (10), the method comprising:
selecting a pressure port (21) comprising a base (42) and a neck (41), the neck (41) radially offset from a central axis (Z) of the base (42);
disposing an electronics package (24) alongside the neck (41) of the pressure port (21), the electronics package (24) configured for sensing pressure in the pressure port (21); and
disposing a housing (22) over the base (42), the pressure port (21) and the electronics package (24).

9. The method as in claim 8, further comprising disposing at least one strain gauge on the pressure port (21).

10. The method as in claim 8, further comprising disposing at least one printed circuit board onto a carrier (23).

11. The method as in claim 10, further comprising disposing the carrier (23) over the pressure port (21).

12. The method as in claim 8, further comprising coupling the electronics package (24) to at least one pressure sensor (7) disposed on the pressure port (21).

13. The method as in claim 12, where in the coupling comprises bonding at least one bonding wire (32) to the at least one pressure sensor (7).

14. The method as in claim 8, wherein disposing the housing (22) comprises joining the housing (22) to the base (42).

15. The method as in claim 8, further comprising disposing a connector (40) onto the housing (22).
